# EUROPÄISCHE PATENTANMELDUNG

(11) **EP 0 831 522 A1**
(43) Veröffentlichungstag der Anmeldung: **25.03.1998**
(21) Anmeldenummer: 97116115.3
(22) Anmeldetag: 17.09.1997
(51) Int. Cl.: H01L 21/306, H01L 33/00, H01L 21/3063

(54) **Verfahren und Vorrichtung zur beleuchtungsunterstützten Strukturierung von porösem Silicium**

(30) Priorität: 21.09.1996 DE 19638881
(71) Anmelder: FORSCHUNGSZENTRUM JÜLICH GMBH, 52425 Jülich (DE)
(72) Erfinder: Thönissen, Markus, 41334 Nettetal (DE); Krüger, Michael, 52062 Aachen (DE); Lüth, Hans, Prof., 52076 Aachen (DE); Berger, Michael Götz, 53343 Wachtberg-Pech (DE); Theiss, Wolfgang, 52078 Aachen (DE); Lerondel, Gilles, 76560 Doudeville (FR); Romestain, Robert, 38400 St. Martin d'Heres (FR)

(57) **Zusammenfassung**

Ein Verfahren zur Herstellung eines strukturierten Bereichs aus porösem Silicium auf einem Substrat, in welchem Silicium mittels Beleuchtung geätzt und strukuriert wird, umfaßt den Schritt, die Beleuchtung wahlweise während oder nach der Ausbildung des porösen Siliciums direkt auf einen ausgewählten Bereich eines p-dotierten Substrats zu richten, um in einem anderen Bereich die Ätzung und Strukturierung porösen Siliciums zu bewirken. Eine Vorrichtung Durchführung des Verfahrens umfaßt eine Beleuchtungseinrichtung zum Unterstützen eines Ätzvorganges und zum Strukurieren des porösen Siliciums, wobei die Beleuchtungseinrichtung wahlweise während oder nach der Ausbildung des porösen Siliciums direkt auf einen ausgewählten Bereich eines p-dotierten Substrats gerichtet ist, um in einem anderen Bereich die Ätzung und Strukturierung porösen Siliciums zu bewirken.

## Beschreibung

Die vorliegende Erfindung betrifft ein Verfahren zur Herstellung eines strukturierten Bereichs aus porösem Silicium auf einem Substrat, in welchem Silicium durch Beleuchtung geätzt und strukturiert wird sowie eine Vorrichtung gemäß Oberbegriff von Anspruch 10.

Poröses Silicium (PS) ist aufgrund seiner Kompatibilität zur hochentwickelten Si-Mikroelektronik sowie seiner einfachen und preiswerten Herstellbarkeit ein vielversprechendes Material für Anwendungen in der Sensorik. Es ist zudem aufgrund seiner Elektrolumineszenz auch sehr gut für Anwendungen im Bereich der Displaytechnologie geeignet. Letzterem kommt insofern eine große Bedeutung zu, als daß Display und Ansteuerung auf einem Chip integriert werden können. Im Hinblick auf die Verwendbarkeit von porösem Silicium sowohl als aktiv leuchtendes Material (z. B. für Pixel in Flachbildschirmen) als auch als passives Material (z. B. der Einsatz als Filter in Farbdetektoren) kommt der einfachen und preiswerten Strukturierung eine große Bedeutung zu.

Aus dem Stand der Technik ist ein eingangs genanntes Verfahren bzw. eine Vorrichtung und ein Bauelement, die durch ein solches Verfahren hergestellt werden, bekannt. Die strukturierten Bereichen aus porösem Silicium werden bisher mittels normaler Photolithographie hergestellt, wobei handelsüblicher Photolack oder beispielsweise Silicium-Nitrid verwendet wird. Poröses Silicium wird in einem elektrochemischen Ätzprozeß unter Verwendung eines Flußsäure/Ethanol Gemisches hergestellt. Eine Beleuchtung der Schichten führt zu einer beleuchtungsabhängigen zusätzlichen Generation von Elektron-Loch Paaren sowohl im Substrat als auch im schon geätzten porösen Silicium, wobei die Löcher für die zum Ätzprozeß notwendige, chemische Reaktion verwendet werden.

Dies hat die Nachteile, daß mehrere, aufeinanderfolgende Prozeßschritte erforderlich sind und die Photolack- bzw. Nitridschicht stabil gegenüber dem Elektrolyten sein muß, der zur elektrochemischen Herstellung von porösem Silicium verwendet wird.

Die Aufgabe der vorliegenden Erfindung ist daher, ein Verfahren zur Herstellung eines strukturierten Bereichs aus porösem Silicium auf einem Substrat zu schaffen, das ohne die Verwendung von Photolithographie eine im Vergleich zu den sehr aufwendigen Photolithographieschritten sehr einfache und preisgünstige Herstellungsmöglichkeit liefert sowie eine Vorrichtung zur Durchführung eines solchen Verfahrens zu schaffen.

Die Aufgabe wird dadurch gelöst, daß die Beleuchtung wahlweise während oder nach der Ausbildung des porösen Siliciums direkt auf einen ausgewählten Bereich eines p-dotierten Substrats gerichtet ist, um in einem anderen Bereich die Ätzung und Strukturierung porösen Siliciums zu bewirken.

Die Aufgabe wird zudem dadurch gelöst, daß die Beleuchtungseinrichtung wahlweise während oder nach der Ausbildung des porösen Siliciums direkt auf einen ausgewählten Bereich eines p-dotierten Substrats gerichtet ist, um poröses Silicium auszubilden und zu strukturieren.

Bei dem erfindungsgemäßen Verfahren werden an Stelle der Photolithographie die gewünschten Strukturen aus porösem Silicium selektiv direkt durch Beleuchtung der Probe während des Herstellungsprozesses geätzt und strukturiert.

Weitere Vorteile der vorliegenden Erfindung sind in den Unteransprüchen 2 bis 9 aufgeführt.

Die gleichen Vorteile liegen auch für die erfindungsgemäße Vorrichtung gemäß Anspruch 10 bis 18 vor.

Eine Ausführungsform der Vorrichtung wird anhand der Zeichnungen näher beschrieben. Es zeigen:
- Fig. 1: eine schematische Darstellung der Anordnung einer Beleuchtungseinrichtung zu einem p-Substrat;
- Fig. 2: einen vergrößerten Ausschnitt der Anordnung aus Fig. 1;

Zu unterscheiden ist die Verwendung von n- oder p-dotierten Substraten, auf denen die porösen Schichten nachher strukturiert hergestellt werden sollen. Je nach Dotierung ist die Bandverbiegung an der Grenzfläche Elektrolyt/Si des Substrates unterschiedlich.

### n-Si:

Im Falle von n-Silicium verursacht die Beleuchtung der Proben einen Photostrom, der dem von außen angelegten Strom für das anodische Ätzen der porösen Schicht vom Vorzeichen her gleich gerichtet ist.

### p-Si:

Für p-Silicium gilt jedoch der umgekehrte Fall. Zwar erfolgt auch hier eine zusätzliche Generation von Elektron-Loch Paaren durch die Beleuchtung der Probe, jedoch hat diese Beleuchtung verschiedenen Konsequenzen: zum einen ist aufgrund der Bandverbiegung in p-dotiertem Material der Photostrom dem von außen, zum Ätzen angelegten Strom, entgegengesetzt gerichtet. Dies bedeutet, daß bei geeigneter Parameterwahl der Ätzstrom durch den Photostrom und somit durch die Beleuchtung kompensiert werden kann. Ein anderer Effekt der Beleuchtung besteht in der zusätzlichen Generation von Elektron-Loch Paaren in den ansonsten schon an Ladungsträgern verarmten Bereichen der porösen Struktur, so daß eine weitere Reduktion des schwammartigen Gerüstes erfolgt und somit eine höhere Porosität der Mikrostruktur erzielt wird.

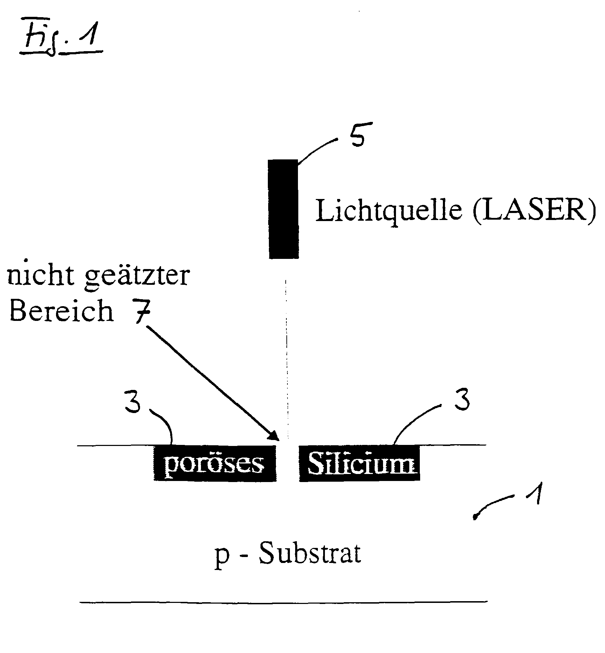

In Fig. 1 ist schematisch ein p-dotiertes Substrat (1) angeordnet, auf welchem ein struktrierter Bereich (3) aus porösem Silicium ausgebildet ist. Oberhalb des p-dotierten Substrats (1) ist eine Beleuchtungseinrichtung (5) als Lichtquelle angeordnet. Die Beleuchtungseinrichtung (5) kann z. B. ein Laser sein und ist auf einen ausgewählten, nicht zu ätzenden Bereich (7) gerichtet.

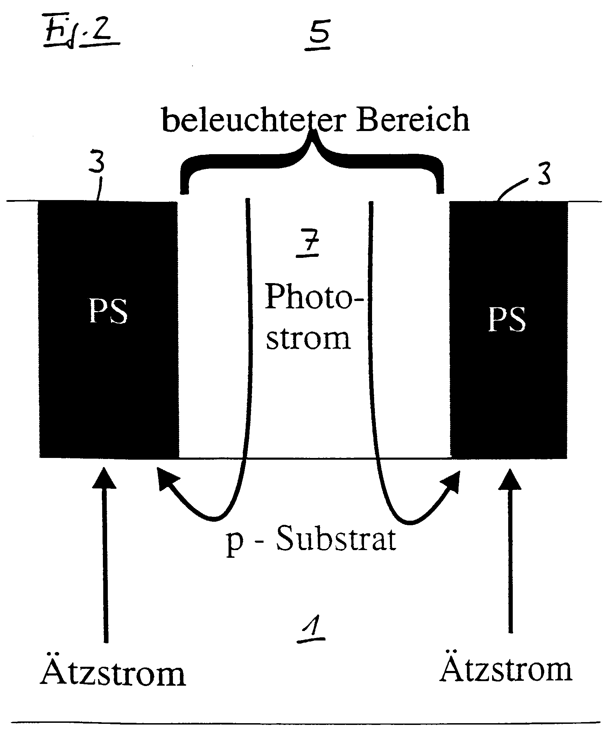

In Fig. 2 ist der Auschnitt des nicht zu ätzenden Bereichs (7) näher dargestellt. In dem ausgewählten, nicht zu ätzenden Bereich (7) fließt aufgrund der Beleuchtung ein Photostrom. Dieser fließt ab in den zu ätzenden und zu strukturierenden Bereich (3) und führt dadurch auch ohne einen angelegten Ätzstrom bereits in diesem zu einem Ätzvorgang, ohne daß der Bereich (7) dabei geätzt wird. Wenn ein Ätzstrom angelegt wird, fließt dieser durch den zu ätzenden und strukturierenden Bereich (3), und kann bei geeigneter Parameterwahl von dem Photostrom kompensiert werden.

Das Verfahren zur Herstellung von porösen Bereichen unter Verwendung einer Beleuchtung der Proben während oder nach der Herstellung bzw. die Vorrichtung zur Durchführung des Verfahrens lassen sich in folgenden Ausführungen wie folgt zusammenfassen:
1. Verfahren bzw. Vorrichtung, bei welchem/welcher durch Beleuchtung von p-dotiertem Material während der Herstellung von porösem Silicium der Photostrom durch geeignete Parameterwahl den Ätzstrom kompensiert oder der Photostrom höher als der Ätzstrom ist, so daß die beleuchteten Bereiche **nicht** geätzt werden, während die unbeleuchteten Bereiche geätzt werden und dort eine poröse Schicht entsteht (Fig. 1, Fig. 2).
2. Verfahren bzw. Vorrichtung wie unter 1., jedoch daß die Probe nur beleuchtet wird, ohne daß ein Ätzstrom angelegt wird. Durch den in die unbeleuchteten Bereiche abfließenden Photostrom können die unbeleuchteten Bereiche auch ohne äußeren Stromfluß nur durch den Photostrom geätzt werden, während in den beleuchteten Bereichen keine poröse Schicht entsteht.
3. Verfahren wie in 1. und 2., jedoch zur Verwendung der lokalen Herstellung von Bereichen unterschiedlicher Porosität, Schichtdicke oder Porosität und Schichtdicke. Die selektive Beleuchtung wird während des Ätzprozesses an- bzw. ausgeschaltet, so daß auch die Mikrostruktur der porösen Schicht selektiv beeinflußt werden kann. Eine mögliche, periodische oder graduelle Änderung der Beleuchtung während oder nach dem Ätzprozeß führt zu den gewünschten Strukturen.

## Patentansprüche

1. Verfahren zur Herstellung eines struktrierten Bereichs aus porösem Silicium auf einem Substrat, in welchem Silicium mittels Beleuchtung geätzt und strukturiert wird,
**dadurch gekennzeichnet**,
daß die Beleuchtung wahlweise während oder nach der Ausbildung des porösen Siliciums direkt auf einen ausgewählten Bereich eines p-dotierten Substrats gerichtet ist, um in einem anderen Bereich die Ätzung und Strukturierung porösen Siliciums zu bewirken.

2. Verfahren nach Anspruch 1,
**dadurch gekennzeichnet**,
daß durch die Beleuchtung ein Photostrom erzeugt wird, der aus dem ausgewählten, beleuchteten Bereich abfließt und einen nicht ausgewählten, unbeleuchteten Bereich ätzt.

3. Verfahren nach Anspruch 2,
**dadurch gekennzeichnet,**
daß ein Photostrom erzeugt wird, der kleiner als ein Ätzstrom ist.

4. Verfahren nach Anspruch 2,
**dadurch gekennzeichnet**,
daß für einen elektrochemischen Ätzprozeß ein Ätzstrom angelegt wird, der durch den Photostrom kompensiert wird.

5. Verfahren nach Anspruch 2,
**dadurch gekennzeichnet**,
daß ein Photostrom erzeugt wird, der höher als der Ätzstrom ist.

6. Verfahren nach einem der Ansprüche 1-5,
**dadurch gekennzeichnet,**
daß die Beleuchtung wahlweise ein- oder ausgeschaltet wird, um eine Mikrostruktur des porösen Siliciums zu beeinflussen.

7. Verfahren nach Anspruch 6,
**dadurch gekennzeichnet**,
daß die Mikrostruktur in ihrer Porosität und/oder Schichtdicke beeinflußt wird.

8. Verfahren nach einem der vorstehenden Ansprüche,
**dadurch gekennzeichnet,**
daß die Beleuchtung periodisch geändert wird.

9. Verfahren nach einem der vorstehenden Ansprüche,
**dadurch gekennzeichnet,**
daß die Beleuchtung lateral graduell geändert wird.

10. Vorrichtung zur Herstellung eines strukturierten Bereichs aus porösem Silicium auf einem Substrat, mit einer Beleuchtungseinrichtung zum Unterstützen eines Ätzvorganges und zum Strukturieren des porösen Siliciums,
**dadurch gekennzeichnet,**
daß die Beleuchtungseinrichtung (5) wahlweise während oder nach der Ausbildung des porösen Siliciums direkt auf einen ausgewählten Bereich (7) eines p-dotierten Substrats (1) gerichtet ist, um in einem anderen Bereich (3) die Ätzung und Strukturierung porösen Siliciums (3) zu bewirken.

11. Vorrichtung nach Anspruch 10,
**dadurch gekennzeichnet**,
daß die Beleuchtungseinrichtung (5) einen Photostrom erzeugt, der aus dem ausgewählten Bereich (7) abfließt und einen nicht ausgewählten, unbeleuchteten Bereich (3) strukuriert.

12. Vorrichtung nach Anspruch 11,
**dadurch gekennzeichnet,**
daß der Photostrom kleiner als der Ätzstrom ist.

13. Vorrichtung nach Anspruch 11,
**dadurch gekennzeichnet,**
daß der Photostrom einen an das Substrat (1) angelegten Ätzstrom kompensiert.

14. Vorrichtung nach Anspruch 11,
**dadurch gekennzeichnet,**
daß der Photostrom höher als der Ätzstrom ist.

15. Vorrichtung nach einem der Anssprüche 10-14,
**dadurch gekennzeichnet,**
daß die Beleuchtungungseinrichtung (5) wahlweise ein- oder ausschaltbar ist, um eine Mikrostruktur des Bereichs (3) aus porösen Silicium zu beeinflussen.

16. Vorrichtung nach Anspruch 15,
**dadurch gekennzeichnet**,
daß die Beleuchtungseinrichtung (5) die Mikrostruktur in ihrer Porosität und/oder Schichtdicke beeinflußt.

17. Vorrichtung nach Anspruch 16
**dadurch gekennzeichnet,**
daß sich die Intensität der Beleuchtungseinrichtung (5) periodisch ändert.

18. Vorrichtung nach einem der vorstehenden Ansprüche,
**dadurch gekennzeichnet,**
daß sich die Intensität der Beleuchtungseinrichtung (5) lateral graduell ändert.
